# EUROPEAN PATENT APPLICATION

(11) **EP 3 012 620 A1**
(43) Date of publication of application: **27.04.2016**
(21) Application number: 14813733.4
(22) Date of filing: 03.06.2014
(51) Int. Cl.: G01N 23/207, C30B 29/06, C01B 33/02

(54) **METHOD FOR EVALUATING CRYSTALLINITY OF POLYCRYSTALLINE SILICON**

(30) Priority: 21.06.2013 JP 2013130411
(71) Applicant: Shin-Etsu Chemical Co., Ltd., Tokyo 100-0004 (JP)
(72) Inventor: MIYAO, Shuichi, Joetsu-shi, Niigata 942-8601 (JP); NETSU, Shigeyoshi, Joetsu-shi, Niigata 942-8601 (JP)
(74) Representative: Smaggasgale, Gillian Helen
(86) International application number: PCT/JP2014/002920
(87) International publication number: WO 2014/203474

(57) **Abstract**

The method for evaluating crystallinity of polycrystalline silicon includes: disposing a collected plate sample (20) at a position where Bragg reflection from a first Miller index plane <h¹k¹l¹> is detected; rotating the plate sample (20) in-plane about the center thereof by a rotation angle φ so that an X-ray irradiation region defined by a slit φ-scans a principal plane of the plate sample (20); determining a chart showing the dependence of intensity of the Bragg reflection from the Miller index plane <hkl> on the rotation angle (φ) of the plate sample (20); determining a diffraction intensity value (I_{B}¹) of a baseline from the chart; similarly determining a diffraction intensity value (I_{B}²) of a baseline from a φ scan chart obtained from a second Miller index plane <h²k²1²>; and using size relation between the I_{B}¹ value and the I_{B}² value as an evaluation index of the crystallinity of polycrystalline silicon.

## Description

### Technical Field

The present invention relates to a method for evaluating crystallinity of polycrystalline silicon by an X-ray diffraction method, and to a method of selecting a polycrystalline silicon rod or a polycrystalline silicon block suitable as a raw material for stably producing single crystal silicon utilizing the evaluation method.

### Background Art

Single crystal silicon indispensable for producing semiconductor devices and the like is crystal-grown by the CZ method and the FZ method, and a polycrystalline silicon rod and a polycrystalline silicon block are used as a raw material in these methods. In many cases, such a polycrystalline silicon material is produced by the Siemens method (see Patent Literature 1 or the like). The Siemens method is a method in which a silane raw material gas such as trichlorosilane and monosilane is brought into contact with a heated silicon core wire to thereby grow (deposit) polycrystalline silicon on the surface of the silicon core wire by the CVD (Chemical Vapor Deposition) method.

For example, when single crystal silicon is crystal-grown by the CZ method, a polycrystalline silicon block is charged in a quartz crucible and melted by heating to obtain silicon melt; a seed crystal is immersed in the silicon melt and a dislocation line is disappeared (dislocation-free growth); and then the crystal is pulled up while gradually increasing the diameter until a predetermined diameter is obtained. If unmelted polycrystalline silicon remains in the silicon melt at this time, the unmelted polycrystalline piece is drifted in the vicinity of an interface of solid and liquid phases by the convection, inducing the generation of dislocation and causing a crystal line to be disappeared.

Further, Patent Literature 2 indicates the following problem: in a step of producing a polycrystalline silicon rod by the Siemens method, needle crystals may be deposited in the rod, and if single crystal silicon is grown by the FZ method using such a polycrystalline silicon rod, the rod does not melt uniformly since the melting of each crystallite depends on the size thereof, and the unmelted crystallites pass through a melt zone to a single crystal rod as solid particles and are incorporated into the solidified surface of the single crystal as unmelted particles, causing the formation of defects.

To this problem, Patent Literature 2 proposes a technique in which the surface of a sample cut out perpendicular to the major axis direction of a polycrystalline silicon rod is ground or polished; the contrast of the surface is increased to such an extent that the microcrystals of the structure can be visually recognized after etching even under an optical microscope; the size of the needle crystals and the area ratio thereof are measured; and the suitability as a raw material for growing FZ single crystal silicon is determined based on the test results.

### Citation List

### Patent Literature

Patent Literature 1:
   Japanese Patent Publication No. 37-18861
Patent Literature 2:
   Japanese Patent Laid-Open No. 2008-285403

### Summary of Invention

### Technical Problem

However, the suitability determination by visual recognition under an optical microscope such as a technique disclosed in Patent Literature 2 easily produces a difference in the results depending on the degree of etching of the surface of an observation sample, an observation skill of a person in charge of evaluation, and the like and in addition is poor in quantitativity and reproducibility. Therefore, from the point of view of increasing the production yield of single crystal silicon, it is necessary to set the criterion of suitability determination of polycrystalline silicon serving as a raw material at a high level, and as a result, the defective rate of a polycrystalline silicon rod will be increased.

Further, according to the investigation of the present inventors, it is observed in the technique disclosed in Patent Literature 2 that even when a polycrystalline silicon rod determined to be non-defective is used, dislocation may be produced and a crystal line may disappear in the step of growing a single crystal silicon rod by the FZ method, and on the other hand, even when a polycrystalline silicon rod determined to be defective is used, an FZ single crystal may be satisfactorily obtained.

Therefore, in order to stably produce single crystal silicon with a high yield, a high technique of selecting polycrystalline silicon suitable as a raw material for producing single crystal silicon with high quantitativity and reproducibility is required.

The present invention has been made in view of the above problems and has an object to provide a technique of selecting polycrystalline silicon suitable as a raw material for producing single crystal silicon with high quantitativity and reproducibility and contributing to the stable production of single crystal silicon.

### Solution to Problem

In order to solve the above problems, the method for evaluating crystallinity of polycrystalline silicon according to the present invention comprises a method for evaluating crystallinity of polycrystalline silicon by an X-ray diffraction method, the method comprising: preparing a plate sample of the polycrystalline silicon; disposing the plate sample at a position where Bragg reflection from a first Miller index plane <h¹k¹l¹> is detected; rotating the plate sample in-plane about the center thereof by a rotation angle φ so that an X-ray irradiation region defined by a slit φ-scans a principal plane of the plate sample; determining a chart showing the dependence of intensity of the Bragg reflection from the Miller index plane on the rotation angle (φ) of the plate sample; determining a diffraction intensity value (I_{B}¹) of a baseline from the chart; similarly determining a diffraction intensity value (I_{B}²) of a baseline from a φ scan chart obtained from a second Miller index plane <h²k²l²>; and using size relation between the I_{B}¹ value and the I_{B}² value as an evaluation index of the crystallinity of polycrystalline silicon.

Preferably, the first and second Miller index planes are a plane <111 > and a plane <220>.

Further, the method for selecting a polycrystalline silicon rod according to the present invention comprises a method for selecting a polycrystalline silicon rod to be used as a raw material for producing single crystal silicon by an X-ray diffraction method, the polycrystalline silicon rod being grown by deposition by a chemical vapor deposition method, the method for selecting the polycrystalline silicon rod comprising: collecting a plate sample having a section perpendicular to a diameter direction of the polycrystalline silicon rod as a principal plane; disposing the plate sample at a position where Bragg reflection from a first Miller index plane <h¹k¹l¹> is detected; rotating the plate sample in-plane about the center thereof by a rotation angle φ so that an X-ray irradiation region defined by a slit φ-scans the principal plane of the plate sample; determining a chart showing the dependence of intensity of the Bragg reflection from the Miller index plane on the rotation angle (φ) of the plate sample; determining a diffraction intensity value (I_{B}¹) of a baseline from the chart; similarly determining a diffraction intensity value (I_{B}²) of a baseline from a φ scan chart obtained from a second Miller index plane <h²k²l²>; and using size relation between the I_{B}¹ value and the I_{B}² value as a criterion to determine the suitability as a raw material for producing single crystal silicon.

Preferably, the first and second Miller index planes are a plane <111 > and a plane <220>.

In a preferred embodiment, a polycrystalline silicon rod is selected as a raw material for producing single crystal silicon in the case where, when the plate sample is collected from a polycrystalline silicon rod having a radius of R at a position of R/3 or less from the center of the rod in the diameter direction and subjected to the φ scan to determine the diffraction intensity value (I_{B} value) of the baseline, the I_{B}^{<111>} value of the Miller index plane <111> is higher than the I_{B}^{<220>} value of the Miller index plane <220>; and when the plate sample is collected from the polycrystalline silicon rod having a radius of R at a position of 2R/3 or more and 3R/3 or less from the center of the rod in the diameter direction and subjected to the φ scan to determine the diffraction intensity value (I_{B}) of the baseline, the I_{B}^{<220>} value of the Miller index plane <220> is higher than the I_{B}^{<111>} value of the Miller index plane <111>.

For example, the polycrystalline silicon rod has been grown by the Siemens method.

In the method for producing single crystal silicon according to the present invention, a polycrystalline silicon rod selected by the method as described above or a polycrystalline silicon block obtained by crushing the polycrystalline silicon rod is used as a raw material.

### Advantageous Effects of Invention

With respect to the polycrystalline silicon rod selected by the method of the present invention, heat flow is believed to be achieved in the crystals such that a local unmelted state hardly occurs. Therefore, a local unmelted state is suppressed and the stable production of single crystal silicon is achieved, when a single crystal is grown by the FZ method using such a polycrystalline silicon rod, or when a single crystal is grown by the CZ method using a polycrystalline silicon block obtained by crushing the polycrystalline silicon rod.

### Brief Description of Drawings

[Figure 1 A] Figure 1A is a view for describing an example of collecting a plate sample for measuring X-ray diffraction from a polycrystalline silicon rod grown by deposition by a chemical vapor deposition method.
[Figure 1 B] Figure 1 B is a view for describing an example of collecting a plate sample for measuring X-ray diffraction from a polycrystalline silicon rod grown by deposition by a chemical vapor deposition method.
[Figure 2] Figure 2 is a view for describing the outline of an example of a system of measurement for determining an X-ray diffraction profile from a plate sample by the θ-2θ method.
[Figure 3] Figure 3 is an example of a θ-2θ X-ray diffraction chart.
[Figure 4] Figure 4 is a view for describing the outline of an example of a system of measurement for determining an X-ray diffraction profile from a plate sample by the φ scan method.
[Figure 5] Figure 5 is an example of the charts obtained by performing then φ scan measurement shown in Figure 4 on the Miller index planes <111 >, <220>, <311>, and <400>.
[Figure 6] Figure 6 is a view for describing the outline of an example of another system of measurement for determining the X-ray diffraction profile from a plate sample by the φ scan method.
[Figure 7] Figure 7 is an example of the charts obtained by performing then φ scan measurement shown in Figure 6 on the Miller index planes <111 >, <220>, <311>, and <400>.
[Figure 8] Figure 8 is a view for describing the outline of an example of another system of measurement for determining the X-ray diffraction profile from a plate sample by the φ scan method.
[Figure 9] Figure 9 shows an example of the φ scan chart on the Miller index planes <111> and <220> of a plate sample.

### Description of Embodiments

In the investigations on the improvement of quality of polycrystalline silicon for stably producing single crystal silicon, the present inventors have obtained the knowledge that a difference is produced in the degree of crystallinity contained in a polycrystalline silicon rod by the difference in various conditions during the deposition of polycrystalline silicon.

Unlike single crystal silicon, a block of polycrystalline silicon contains a large number of crystallites and crystal grains, and crystal planes thereof each tend to be considered to face in random directions (randomly oriented). However, according to the investigations of the present inventors, the crystals contained in the polycrystal silicon block are not necessarily completely randomly oriented.

When the present inventors have collected plate samples each having a section perpendicular to a diameter direction as a principal plane from a large number of different polycrystalline silicon rods grown by deposition by a chemical vapor deposition method and investigated Bragg reflection intensity from a Miller index plane <hkl> by the same technique as described above, it has been found that the value (diffraction intensity) of a baseline of a chart of the Bragg reflection intensity from the Miller index plane <hkl> has varied according to the samples with the production conditions of the polycrystalline silicon rods.

Further, according to the investigations of the present inventors, when samples have been collected from a large number of polycrystalline silicon rods; various Miller index planes of each sample have been measured for Bragg reflection intensity; and formation of a single crystal has been attempted by the FZ method using each polycrystalline silicon rod as a raw material, it has been found that when size relation between the Miller index planes, in which the diffraction intensity values (I_{B}) of the baselines appearing in the charts of the Bragg reflection intensity described above are different, satisfies a specific condition, a crystal line does not disappear in the step of forming a single crystal, while when the specific condition is not satisfied, the probability for a crystal line to disappear in the step of forming a single crystal is high.

That is, crystal grains in a polycrystalline silicon rod are not necessarily randomly oriented, but the "crystallinity" of polycrystalline silicon depends on various conditions during deposition.

Patent Literature 2 as described above discloses that when the proportion of needle crystals which are present in a polycrystalline silicon rod is high, a crystal line will disappear when the single crystal is pulled up by the FZ method. Particularly, needle crystals which are present in the inner region of a polycrystalline silicon rod are easily in an unmelted state even after passing the "drawn" portion which is a floating zone (heat melting zone) during the FZ pulling up, thus disappearing the crystal line.

Certainly, if such needle crystals as described in Patent Literature 2 are present in a polycrystalline silicon rod, the needle crystals will be easily in an unmelted state locally, which, as a result, will cause to disappear the crystal line during pulling up of the single crystal by the FZ method.

However, according to the investigations of the present inventors, even when single crystal silicon is grown by the FZ method using, as a raw material, a polycrystalline silicon rod in which the presence of such needle crystals is not observed at all, there has been observed the apparent influence of production conditions (temperature, gas flow rate, TSC concentration, and the like) of the polycrystalline silicon rod on the presence or absence of the disappearance of the crystal line. That is, the crystallinity of a polycrystalline silicon rod suitable as a raw material for producing single crystal silicon cannot sufficiently be macroscopically evaluated from the point of view of the existence or nonexistence, the density, or the location of needle crystals, but should be evaluated from a more microscopic point of view.

Therefore, the present inventors have attempted to evaluate the crystallinity of polycrystalline silicon by an X-ray diffraction method in order to select a polycrystalline silicon rod suitable as a raw material for producing single crystal silicon.

As a result, it has been concluded that the following technique is effective for solving the above problems, the technique including: collecting a plate sample having a section perpendicular to a diameter direction of a polycrystalline silicon rod as a principal plane; disposing the plate sample at a position where Bragg reflection from a first Miller index plane <h¹k¹l¹> is detected; rotating the plate sample in-plane about the center thereof by a rotation angle φ so that an X-ray irradiation region defined by a slit φ-scans the principal plane of the plate sample; determining a chart showing the dependence of intensity of the Bragg reflection from the Miller index plane on the rotation angle (φ) of the plate sample; determining a diffraction intensity value (I_{B}¹) of a baseline from the chart; similarly determining a diffraction intensity value (I_{B}²) of a baseline from a φ scan chart obtained from a second Miller index plane <h²k²l²>; and using size relation between the I_{B}¹ value and the I_{B}² value as a criterion to determine the suitability as a raw material for producing single crystal silicon.

When a polycrystalline silicon rod is produced, the amount of raw material gas supplied per the surface area and the surface temperature also change with the growth of the silicon rod. Therefore, with respect to the region dependence of the crystallinity of a polycrystalline silicon rod, the region dependence in the radial direction of the silicon rod tends to be higher than the region dependence in the major axis direction (stretching direction) thereof.

Then, according to the investigations of the present inventors, the region dependence of the crystallinity in the radial direction depends on the production conditions of a polycrystalline silicon rod, and a certain tendency is observed in polycrystalline silicon in which a crystal line does not disappear when used as a raw material for producing single crystal silicon.

Specifically, when a polycrystalline silicon rod is used as a raw material for producing single crystal silicon, a crystal line in the polycrystalline silicon rod hardly disappears in the case where, when the plate sample is collected from a polycrystalline silicon rod having a radius of R at a position of R/3 or less from the center of the rod in the diameter direction and subjected to the φ scan to determine the diffraction intensity value (I_{B}) of the baseline, the I_{B}^{<111>} value of the Miller index plane <111> is higher than the I_{B}^{<220>} value of the Miller index plane <220>; and when the plate sample is collected from the polycrystalline silicon rod having a radius of R at a position of 2R/3 or more and 3R/3 or less from the center of the rod in the diameter direction and subjected to the φ scan to determine the diffraction intensity value (I_{B}) of the baseline, the I_{B}^{<220>} value of the Miller index plane <220> is higher than the I_{B}^{<111>} value of the Miller index plane <111>.

In the present invention, a polycrystalline silicon rod is selected by the above method, and the selected polycrystalline silicon rod is used as a silicon raw material to produce single crystal silicon, or a polycrystalline silicon block obtained by crushing the selected polycrystalline silicon rod is used as a silicon raw material to produce single crystal silicon. Thereby, the occurrence of a problem of the disappearance of a crystal line in the formation of a single crystal can be suppressed.

Hereinafter, the embodiments of the present invention will be described with reference to drawings.

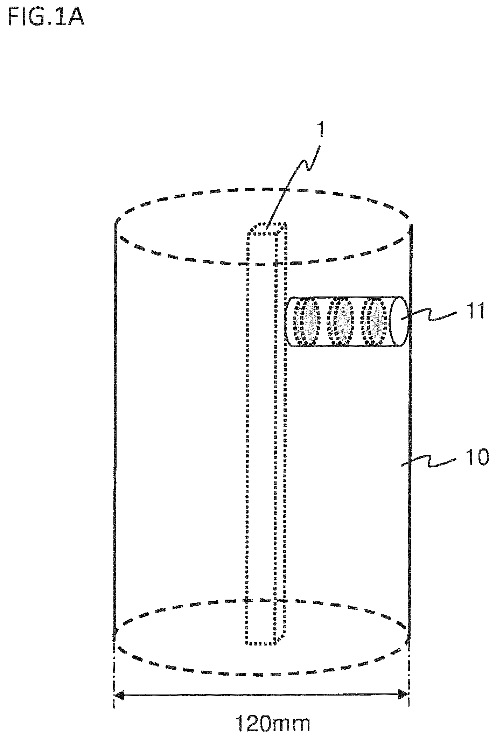

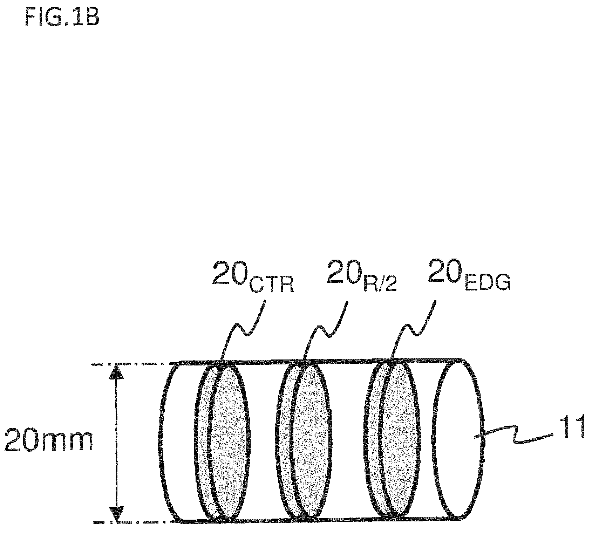

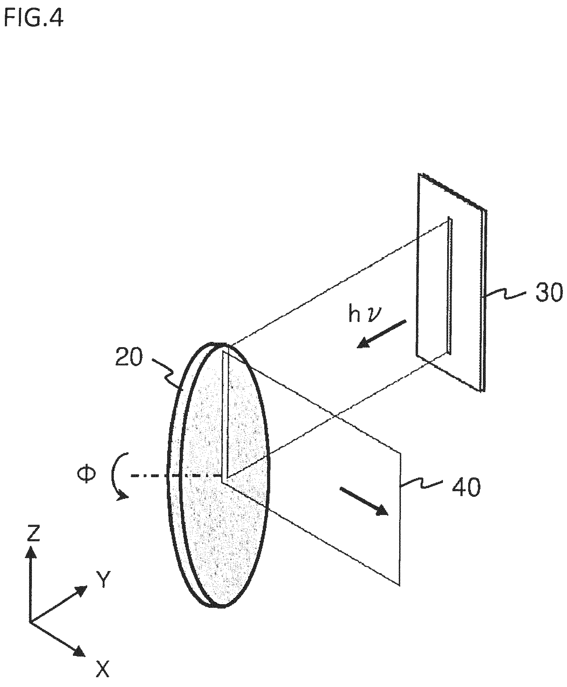

Figure 1A and Figure 1B are views for describing examples of collecting plate samples 20 for measuring X-ray diffraction profiles from a polycrystalline silicon rod 10 grown by deposition by a chemical vapor deposition method such as the Siemens method. In Figure 4A, reference numeral 1 denotes a silicon core wire for depositing polycrystalline silicon on the surface thereof to form a silicon rod.

Note that, in this example, the plate samples 20 are collected from three regions (CTR: a region close to the silicon core wire 1, EDG: a region close to the sidewall of the polycrystalline silicon rod 10, R/2: an intermediate region between CTR and EGD) in order to check the presence or absence of the diameter direction dependence of the crystallinity of the polycrystalline silicon rod 10.

The diameter of the polycrystalline silicon rod 10 illustrated in Figure 1A is about 120 mm, and a rod 11 having a diameter of about 20 mm and a length of about 60 mm is hollowed out from the sidewall side of the polycrystalline silicon rod 10 perpendicularly to the longitudinal direction of the silicon core wire 1.

Then, as illustrated in Figure 1 B, disk samples (20_{CTR}, 20_{EDG}, and 20_{R/2}), each having a section perpendicular to the direction of the diameter of the polycrystalline silicon rod 10 as a principal plane and having a thickness of about 2 mm, are collected from the region close to the silicon core wire 1 (CTR), the region close to the sidewall of the polycrystalline silicon rod 10 (EDG), and the intermediate region between CTR and EGD (R/2), respectively, of the rod 11.

Note that, although the region from which the rod 11 is collected and the length and the numbers of the rod 11 may be suitably determined depending on the diameter of the silicon rod 10 and the diameter of the rod 11 to be hollowed out, and the disk samples 20 may also be collected from any region of the hollowed-out rod 11, the rod and the disk samples are preferably collected from positions where the overall properties of the silicon rod 10 can be rationally estimated.

For example, when three disk samples are acquired, it is preferred to acquire the three samples from three positions, that is, central part, a position located at 1/2, from the center, of the radius of the circumference of a silicon rod and a position located outside the point.

Further, a diameter of the disk sample 20 of about 20 mm is for illustration only, and the diameter may be suitably determined in the range where the X-ray diffraction measurement can be performed without any trouble.

In the present invention, when the crystallinity of polycrystalline silicon is evaluated by an X-ray diffraction method, a disk sample 20 collected as described above is disposed at a position where Bragg reflection from a Miller index plane <hkl> is detected; the disk sample 20 is rotated in-plane about the center thereof by a rotation angle φ so that an X-ray irradiation region defined by a slit φ-scan the principal plane of the disk sample 20; a chart showing the dependence of intensity of the Bragg reflection from the Miller index plane <hkl> on the rotation angle (φ) of the disk sample 20 is determined; a baseline is determined from the chart; and the diffraction intensity value (I_{B}) of the baseline is used as an evaluation index of the crystallinity.

Here, according to the investigations of the present inventors, since the peaks from Miller index planes <111 >, <220>, <311>, and <400> are particularly effective for evaluating crystallinity, it is preferred to compare the I_{B} values of the Miller index planes <111 >, <220>, <311 >, and <400>, as the above Miller index plane <hkl>. Particularly, it is effective to compare the I_{B} value of the plane <111> with the I_{B} value of the plane <220>.

Further, the crystallinity evaluation method as described above is utilized in the present invention for selecting a polycrystalline silicon rod to be used as a raw material for producing single crystal silicon by an X-ray diffraction method.

That is, the method for selecting a polycrystalline silicon rod according to the present invention comprises a method for selecting a polycrystalline silicon rod to be used as a raw material for producing single crystal silicon by an X-ray diffraction method, the polycrystalline silicon rod being grown by deposition by a chemical vapor deposition method, the method for selecting the polycrystalline silicon rod comprising: collecting a plate sample having a section perpendicular to a diameter direction of the polycrystalline silicon rod as a principal plane; disposing the plate sample at a position where Bragg reflection from a first Miller index plane <h¹k¹l¹> is detected; rotating the plate sample in-plane about the center thereof by a rotation angle φ so that an X-ray irradiation region defined by a slit φ-scan the principal plane of the plate sample; determining a chart showing the dependence of intensity of the Bragg reflection from the Miller index plane on the rotation angle (φ) of the plate sample; determining a diffraction intensity value (I_{B}¹) of a baseline from the chart; similarly determining a diffraction intensity value (I_{B}²) of a baseline from a φ scan chart obtained from a second Miller index plane <h²k²l²>; and using size relation between the I_{B}¹ value and the I_{B}² value as a criterion to determine the suitability as a raw material for producing single crystal silicon.

Also here, it is preferred to compare the I_{B} values of the Miller index planes <111 >, <220>, <311 >, and <400>, as the above Miller index plane <hkl>. Particularly, it is effective to compare the I_{B} value of the plane <111 > with the I_{B} value of the plane <220>.

In a preferred embodiment, a polycrystalline silicon rod is selected as a raw material for producing single crystal silicon in the case where, when the plate sample is collected from a polycrystalline silicon rod having a radius of R at a position of R/3 or less from the center of the rod in the diameter direction and subjected to the φ scan to determine the diffraction intensity value (I_{B}) of the baseline, the I_{B}^{<111>} value of the Miller index plane <111> is higher than the I_{B}^{<220>} value of the Miller index plane <220>; and when the plate sample is collected from the polycrystalline silicon rod having a radius of R at a position of 2R/3 or more and 3R/3 or less from the center of the rod in the diameter direction and subjected to the φ scan to determine the diffraction intensity value (I_{B}) of the baseline, the IB^{<220>} value of the Miller index plane <220> is higher than the I_{B}^{<111>} value of the Miller index plane <111>.

How to define a baseline appearing in a φ scan chart of the Miller index plane <hkl> of a plate sample and the like will be described below, taking the φ scan charts of the Miller index planes <111> and <220> as an example.

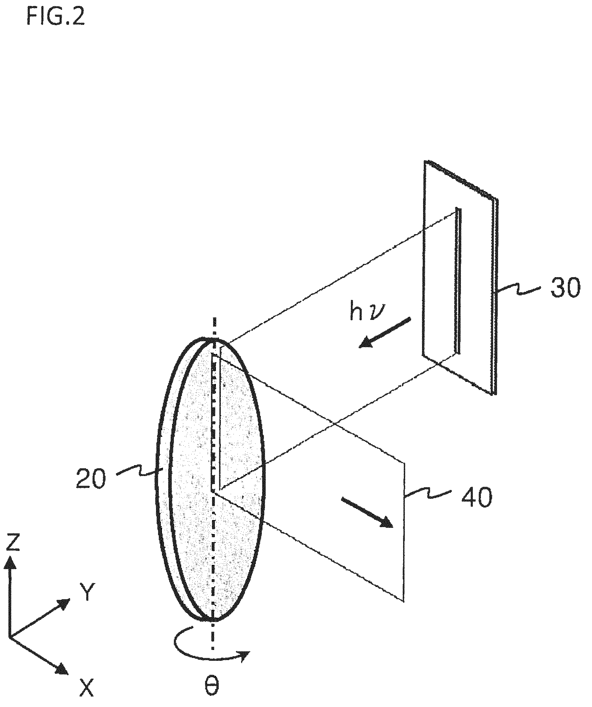

Figure 2 is a view for describing the outline of an example of a system of measurement for determining the X-ray diffraction profile from a disk sample 20 by a so-called 0-20 method. An X-ray beam 40 (Cu-Kα rays: wavelength of 1.54 A) emitted from a slit 30 and collimated is incident into the disk sample 20. The intensity of the diffracted X-ray beam per each sample rotation angle (θ) is detected with a detector (not illustrated) while rotating the disk sample 20 in an XY plane to obtain a 0-20 X-ray diffraction chart.

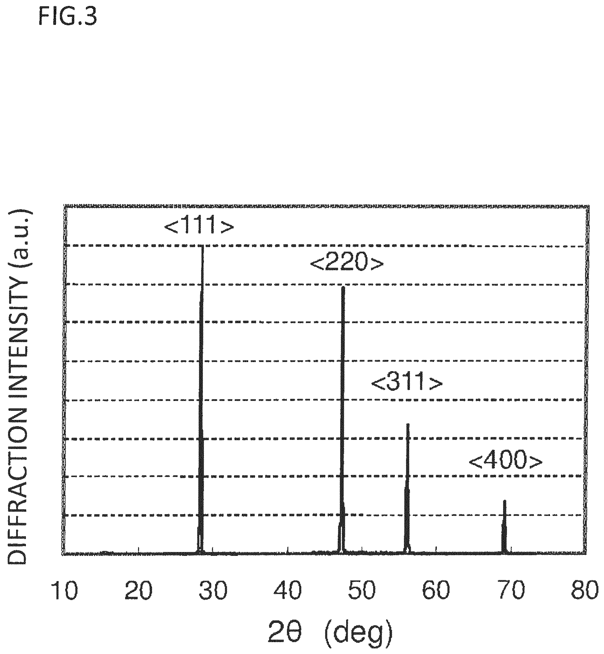

Figure 3 shows the example of the θ-2θ X-ray diffraction chart obtained above, in which strong Bragg reflections from the Miller index planes <111>, <220>, <311 >, and <400> appear as peaks at positions of 20 = 28.40°, 47.24°, 55.98°, and 68.98°, respectively.

Figure 4 is a view for describing the outline of a system of measurement for determining the X-ray diffraction profile from a disk sample 20 by a so-called φ scan method. For example, the above θ of the disk sample 20 is set to an angle from which the Bragg reflection from the Miller index plane <111> is detected. In this state, the region from the center of the disk sample 20 to the peripheral edge thereof is irradiated with X-rays in a narrow rectangular region provided by a slit. The disk sample 20 is rotated about the center thereof in a YZ plane (φ = 0° to 360°) so that the X-ray irradiation region may scan the whole area of the disk sample 20.

Figure 4 is a view for describing the outline of a system of measurement for determining the X-ray diffraction profile from a disk sample 20 by a so-called φ scan method. For example, the above θ of the disk sample 20 is set to an angle from which the Bragg reflection from the Miller index plane <111> is detected. In this state, the region from the center of the disk sample 20 to the peripheral edge thereof is irradiated with X-rays in a narrow rectangular region defined by a slit. The disk sample 20 is rotated about the center thereof in a YZ plane (φ = 0° to 360°) so that the X-ray irradiation region may scan the whole area of the disk sample 20.

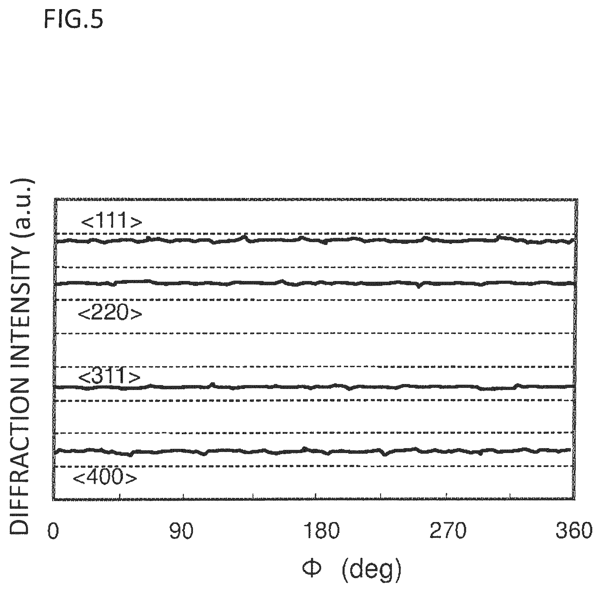

Figure 5 is an example of the charts obtained by performing the above φ scan measurement on the Miller index planes <111 >, <220>, <311 >, and <400>. In this example, the Bragg reflection intensity is generally constant even when any of the above Miller index planes is paid attention to, and the Bragg reflection intensity is hardly dependent on the rotation angle φ. Thus, these charts are similar to the chart of a powder sample.

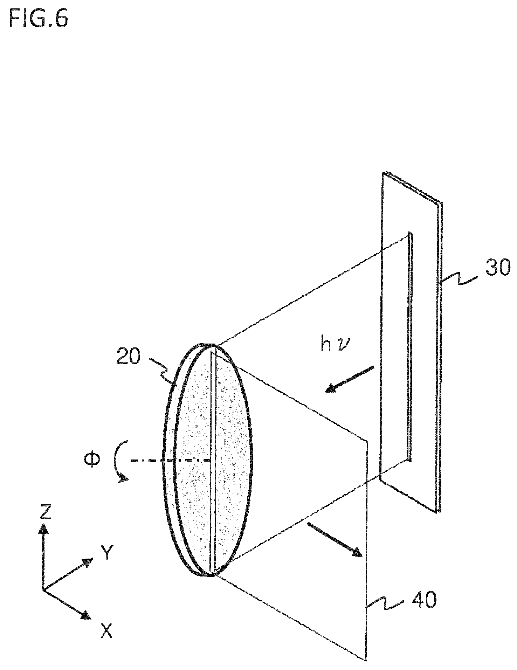

Figure 6 is a view for describing the outline of an example of another system of measurement for determining the X-ray diffraction profile from a disk sample 20 by the φ scan method. In the example shown in this view, the region over both the peripheral edges of the disk sample 20 is irradiated with X-rays in a narrow rectangular region provided by a slit. The disk sample 20 is rotated about the center thereof in a YZ plane (φ = 0° to 180°) so that the X-ray irradiation region may scan the whole area of the disk sample 20.

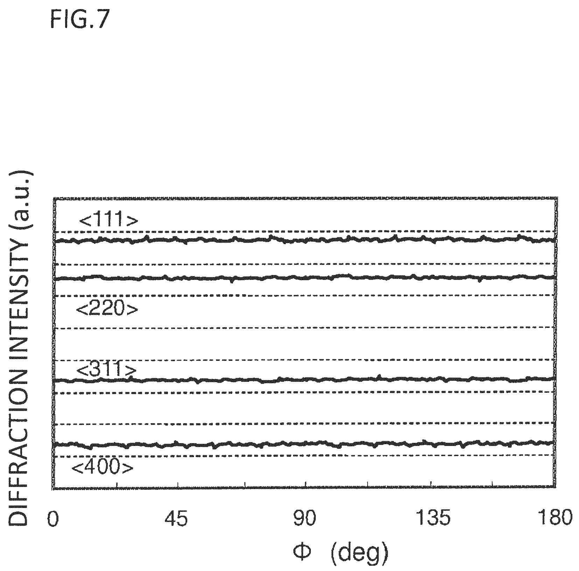

Figure 7 is an example of the chart obtained by performing the above, scan measurement on the Miller index planes <111 >, <220>, <311 >, and <400>, and a φ scan chart substantially the same as that shown in Figure 5 has been obtained.

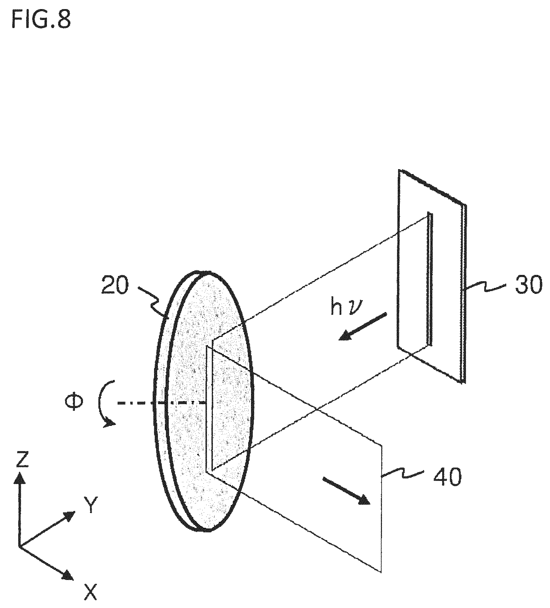

Figure 8 is a view for describing the outline of an example of another system of measurement for determining the X-ray diffraction profile from a disk sample 20 by the φ scan method. In the example shown in this view, only the inner peripheral region of the disk sample 20 instead of the whole principal plane thereof is irradiated with X-rays. The disk sample 20 is rotated about the center thereof in a YZ plane (φ = 0° to 180°) so that the X-ray irradiation region may scan the whole area of the disk sample 20.

When treatment is performed in which a difference between the φ scan chart obtained from such an X-ray irradiation region and the φ scan chart obtained from the whole principal plane of the disk sample 20 as described above is determined, it will be possible to obtain crystallinity distribution in plane of the disk sample 20.

However, although in-plane crystallinity distribution will probably not occur on the disk sample 20 collected in the embodiment as shown in Figures 1A and 1 B, it is needless to say that the evaluation of the crystallinity according to the present invention is significant not only as a method for selecting a polycrystalline silicon rod grown by the Siemens method or the like but also as a method for evaluating the crystal grain size of polycrystalline silicon by an X-ray diffraction method.

Therefore, for example, when a disk sample cut out in parallel with the diameter direction of a polycrystalline silicon rod grown by deposition by a chemical vapor deposition method is determined for the in-plane crystallinity distribution, it will also be possible to know the crystallinity distribution (distribution of the degree of random orientation) in a polycrystalline silicon rod, the change of crystallinity (change of the degree of random orientation) accompanying the enlargement of the diameter of a polycrystalline silicon rod, or the like, thereby allowing selection of a polycrystalline silicon rod suitable as a raw material for producing single crystal silicon.

When the φ scan chart on the Miller index plane <hkl> of a plate sample has almost constant diffraction intensity as shown in Figures 5 and 7, this φ scan chart itself can be treated as a "baseline", but "waviness" may be observed in the φ scan chart, depending on a case.

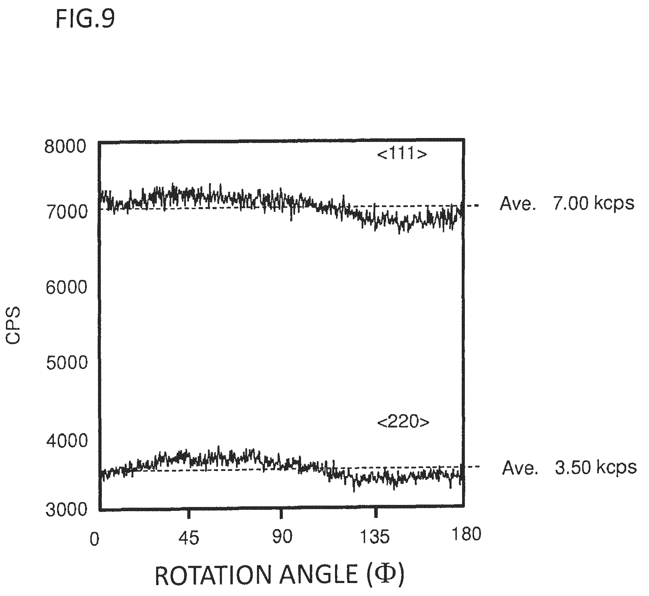

Figure 9 shows an example of the φ scan chart in which the "waviness" is observed on the Miller index planes <111> and <220> of a plate sample. Note that these samples are collected from the same polycrystalline silicon rod, and these φ scan charts are obtained by the measurement of the embodiment shown in Figure 6.

Although "waviness" is observed on the baseline of the φ scan chart of the Miller index plane <111 >, the average diffraction intensity (I_{B}^{ave}) of then φ scan chart is 7.00 kcps, and this value is employed as the I_{B} value of the Miller index plane <111 >.

Similarly, although "waviness" is observed on the baseline of then φ scan chart on the Miller index plane <220>, the average diffraction intensity (I_{B}^{ave}) of the φ scan chart is 3.50 kcps, and this value is employed as the I_{B} value of the Miller index plane <220>.

Note that a φ scan chart not always has almost constant diffraction intensity as shown in Figures 5 and 7, but a peak-like diffraction intensity distribution may appear in a φ scan chart, depending on a case. When peak-like diffraction intensity distribution has appeared in a φ scan chart, the intensity having an S/N ratio of 3 or more is determined to be a "peak"; and the baseline is determined according to a technique of determining the baseline when the peak intensity of the peak part is integrated.

### Examples

Thirteen polycrystalline silicon rods grown under different deposition conditions were prepared. Each of these polycrystalline silicon rods (silicon rods 1 to 13) was used to collect disk samples (20_{CTR}, 20_{EDG}, 20_{R/2}) each having a thickness of about 2 mm from three regions shown in Figures 1A and 1 B, and the samples were used to obtain φ scan charts of the Miller index planes <111> and <220> using the system of measurement shown in Figure 6. Note that the diameter of the disk sample 20 is about 20 mm.

Note that the positions to collect the plate samples are not limited to three regions shown in Figures 1A and 1 B, but may be three positions such as a position of R/3 or less, a position from 1 R/3 to 2R/3, and a position of 2R/3 or more and 3R/3 or less, from the center of the polycrystalline silicon rod having a radius of R.

Table 1 (Examples) and Table 2 (Comparative Examples) summarize the diffraction intensity of the baseline for each of the disk samples obtained from these polycrystalline silicon rods and the disappearance or not of the crystal line when single crystal silicon rods are grown by the FZ method using these polycrystalline silicon rods. Note that the numerical values in the Tables are the diffraction intensity (I_{B}: unit is kcps) of the baseline for each Miller index plane, and the presence or absence of needle crystals was checked by the technique described in Patent Literature 2.

**[Table 1]**

| | | | Sampling positon | | | Disappearance of FZ crystalline |
|---|---|---|---|---|---|---|
| | | | Central part | R/2 | Surface | |
| Example 1 | Silicon rod 1 | <111> | 10.5 | 12 | 7.5 | No |
| | | <220> | 8 | 7 | 12 | |
| | | <111>/<220> | 1.31 | 1.71 | 0.63 | |
| | | Needle crystal | Present | Absent | Absent | |
| Example 2 | Silicon rod 2 | <111> | 7 | 7 | 8.5 | No |
| | | <220> | 4 | 5 | 10 | |
| | | <111>/<220> | 1.75 | 1.40 | 0.85 | |
| | | Needle crystal | Present | Absent | Absent | |
| Example 3 | Silicon rod 3 | <111> | 6 | 7 | 7.2 | No |
| | | <220> | 5 | 6.8 | 7.6 | |
| | | <111>/<220> | 1.20 | 1.03 | 0.95 | |
| | | Needle crystal | Present | Absent | Absent | |
| Example 4 | Silicon rod 4 | <111> | 8 | 8 | 9 | No |
| | | <220> | 4 | 7.5 | 9.5 | |
| | | <111>/<220> | 2.00 | 1.07 | 0.95 | |
| | | Needle crystal | Absent | Absent | Absent | |
| Example 5 | Silicon rod 5 | <111> | 8 | 7 | 7 | No |
| | | <220> | 4 | 7.2 | 7.8 | |
| | | <111>/<220> | 2.00 | 0.97 | 0.90 | |
| | | Needle crystal | Absent | Absent | Absent | |
| Example 6 | Silicon rod 6 | <111> | 10 | 9.5 | 7.5 | No |
| | | <220> | 5.5 | 10 | 8 | |
| | | <111>/<220> | 1.82 | 0.95 | 0.94 | |
| | | Needle crystal | Present | Absent | Absent | |
| Example 7 | Silicon rod 7 | <111> | 7 | 7.5 | 8 | No |
| | | <220> | 6 | 9 | 9 | |
| | | <111>/<220> | 1.17 | 0.83 | 0.89 | |
| | | Needle crystal | Present | Present | Present | |
| Example 8 | Silicon rod 8 | <111> | 12 | 9 | 7.5 | No |
| | | <220> | 9 | 10 | 8 | |
| | | <111>/<220> | 1.33 | 0.90 | 0.94 | |
| | | Needle crystal | Absent | Present | Present | |

**[Table 2]**

| | | | Sampling position | | | Disappearance of FZ crystalline |
|---|---|---|---|---|---|---|
| | | | Central part | R/2 | Surface | |
| Comparative Example 1 | Silicon rod 9 | <111> | 11 | 9 | 8.8 | Yes |
| | | <220> | 5.5 | 4.5 | 5 | |
| | | <111>/<220> | 2.00 | 2.00 | 1.76 | |
| | | Needle crystal | Absent | Absent | Absent | |
| Comparative Example 2 | Silicon rod 10 | <111> | 7 | 8 | 8 | Yes |
| | | <220> | 6 | 9 | 4 | |
| | | <111>/<220> | 1.17 | 0.89 | 2.00 | |
| | | Needle crystal | Absent | Present | Present | |
| Comparative Example 3 | Silicon rod 11 | <111> | 8.5 | 7.5 | 9 | Yes |
| | | <220> | 4 | 3.8 | 5.8 | |
| | | <111>/<220> | 2.13 | 1.97 | 1.55 | |
| | | Needle crystal | Absent | Absent | Absent | |
| Comparative Example 4 | Silicon rod 12 | <111> | 10 | 10 | 9 | Yes |
| | | <220> | 4.5 | 5.5 | 5.5 | |
| | | <111>/<220> | 2.22 | 1.82 | 1.64 | |
| | | Needle crystal | Absent | Absent | Absent | |
| Comparative Example 5 | Silicon rod 13 | <111> | 11 | 7.5 | 9.5 | Yes |
| | | <220> | 6 | 8 | 4 | |
| | | <111>/<220> | 1.83 | 0.94 | 2.38 | |
| | | Needle crystal | Absent | Present | Present | |

With respect to the polycrystalline silicon rods of Examples 1 to 8, when a plate sample is collected from a polycrystalline silicon rod having a radius of R at a position of R/3 or less from the center of the rod in the diameter direction (central part), the I_{B}^{<111>} value of the Miller index plane <111> is higher than the I_{B}^{<220>} value of the Miller index plane <220>, and when a plate sample is collected from a polycrystalline silicon rod having a radius of R at a position of 2R/3 or more and 3R/3 or less from the center of the rod in the diameter direction (surface), the I_{B}^{<220>} value of the Miller index plane <220> is higher than the I_{B}^{<111>} value of the Miller index plane <111 >.

That is, the Miller index plane <111> tends to be oriented in the central part of a polycrystalline silicon rod, while the Miller index plane <220> tends to be oriented on the surface side of a polycrystalline silicon rod.

Further, in all the polycrystalline silicon rods in these Examples, the disappearance of a crystal line has not occurred in the step of forming the FZ single crystal even if these silicon rods contain needle crystals.

On the other hand, with respect to the polycrystalline silicon rods of Comparative Examples 1 to 5, when a plate sample is collected from a polycrystalline silicon rod having a radius of R at a position of R/3 or less from the center of the rod in the diameter direction (central part), the I_{B}^{<111>} value of the Miller index plane <111> is higher than the I_{B}^{<222>} value of the Miller index plane <220>, but the following condition is not satisfied: when a plate sample is collected from a polycrystalline silicon rod having a radius of R at a position of 2R/3 or more and 3R/3 or less from the center of the rod in the diameter direction (surface), the I_{B}^{<220>} value of the Miller index plane <220> is higher than the I_{B}^{<111>} value of the Miller index plane <111 >.

That is, the Miller index plane <111> tends to be oriented on the surface side of a polycrystalline silicon rod in the same manner as in the central part of a polycrystalline silicon rod.

Further, in all the polycrystalline silicon rods in these Comparative Examples, the disappearance of a crystal line has occurred in the step of forming the FZ single crystal including the polycrystalline silicon rods in which needle crystals are not observed.

These results mean that even if single crystal silicon is produced by using, as a raw material, a polycrystalline silicon rod in which macroscopic needle crystals observed by visual observation are not identified, such as that disclosed in Patent Literature 2, the disappearance of the crystal line resulting from the induction of the occurrence of dislocation may occur; and, conversely, even if macroscopic needle crystals are identified in a polycrystalline silicon rod, such a polycrystalline silicon rod will be suitable as a raw material for producing single crystal silicon.

The reason why a crystal line does not disappear when the Miller index plane <111> tends to be oriented in the central part of a polycrystalline silicon rod and the Miller index plane <220> tends to be oriented on the surface side of a polycrystalline silicon rod is interpreted by the present inventors as follows.

Since a plate sample has a section perpendicular to the growth axis direction (diameter direction) of a polycrystalline silicon rod as a principal plane, when the plate sample is subjected to X-ray diffraction measurement, the plane <111> is in agreement with the direction of the growth axis. On the other hand, the direction of the plane <220> is rotated by 45° from the direction of the growth axis.

When thermal diffusivity of a plate sample is measured when the plate sample contains the oriented region of the plane <111> and the oriented region of the plane <220>, a thermal diffusivity depending on the proportion of the oriented region of the plane <111> and the oriented region of the plane <220> will be obtained.

According to the experiments by the present inventors, the thermal diffusivity value has decreased when the oriented region of the plane <220> is dominant, and the thermal diffusivity value has increased when the oriented region of the plane <111> is dominant. This is exactly the result of the heat in polycrystalline silicon propagating in the direction of the crystal axis (perpendicular to the Miller index plane).

In the actual operation of heating and melting in the step of forming the FZ single crystal, when the outside is heated and the orientation of the plane <111> is dominant, the heat is propagated in the direction of the growth axis, while when the orientation of the plane <220> is dominant, the heat propagates in the direction rotated by 45° from the direction of the growth axis. Then, the propagation of the heat in the direction rotated by 45° from the growth axis will contribute to equalize temperature in the major axis direction of a polycrystalline silicon rod.

When a single crystal is grown by the FZ method, the phase change of silicon proceeds at a continuous and constant speed from a solid to a liquid and from a liquid to a solid as described above. In order for such a continuous phase change to proceed without a problem, it is believed that the temperature equalization in the major axis direction of a polycrystalline silicon rod is an extremely important factor.

Such a temperature equalization effect is probably the reason why a crystal line does not disappear when the Miller index plane <220> tends to be oriented on the surface side of a polycrystalline silicon rod.

Incidentally, when the orientation of the plane <220> is dominant in the central part of a polycrystalline silicon rod, the heat in this part propagates in the major axis direction (up-and-down direction) of the polycrystalline silicon rod to facilitate the dissipation of the heat. This part corresponds to the "neck" in which silicon melt is squeezed into a narrow shape in the step of forming the FZ single crystal, which is a region where high temperature is required to be maintained. Therefore, when the orientation of the plane <220> is dominant in the central part of a polycrystalline silicon rod, heat concentration to this part will be prevented, resulting in preventing stable crystal growth.

Such a heat concentration effect is probably the reason why a crystal line does not disappear when the Miller index plane <111> tends to be oriented in the central part of a polycrystalline silicon rod.

### Industrial Applicability

The present invention provides a technique of selecting polycrystalline silicon suitable as a raw material for producing single crystal silicon with high quantitativity and reproducibility and contributing to the stable production of single crystal silicon.

### Reference Signs List

1 Silicon core wire
10 Polycrystalline silicon rod
11 Rod
20 Plate sample
30 Slit
40 X-ray beam

## Claims

1. A method for evaluating crystallinity of polycrystalline silicon by an X-ray diffraction method, the method comprising:
preparing a plate sample of the polycrystalline silicon;
disposing the plate sample at a position where Bragg reflection from a first Miller index plane <h¹k¹l¹> is detected;
rotating the plate sample in-plane about the center thereof by a rotation angle φ so that an X-ray irradiation region defined by a slit φ-scans a principal plane of the plate sample;
determining a chart showing the dependence of intensity of the Bragg reflection from the Miller index plane on the rotation angle (φ) of the plate sample;
determining a diffraction intensity value (I_{B}¹) of a baseline from the chart;
similarly determining a diffraction intensity value (I_{B}²) of a baseline from a φ scan chart obtained from a second Miller index plane <h²k²l²>; and
using size relation between the I_{B}¹ value and the I_{B}² value as an evaluation index of the crystallinity of the polycrystalline silicon.

2. The method for evaluating crystallinity of polycrystalline silicon according to claim 1, wherein the first and second Miller index planes are a plane <111 > and a plane <220>.

3. A method for selecting a polycrystalline silicon rod to be used as a raw material for producing single crystal silicon by an X-ray diffraction method, the polycrystalline silicon rod being grown by deposition by a chemical vapor deposition method, the method for selecting the polycrystalline silicon rod comprising:
collecting a plate sample having a section perpendicular to a diameter direction of the polycrystalline silicon rod as a principal plane;
disposing the plate sample at a position where Bragg reflection from a first Miller index plane <h¹k¹l¹> is detected;
rotating the plate sample in-plane about the center thereof by a rotation angle φ so that an X-ray irradiation region defined by a slit φ-scans the principal plane of the plate sample;
determining a chart showing the dependence of intensity of the Bragg reflection from the Miller index plane on the rotation angle (φ) of the plate sample;
determining a diffraction intensity value (I_{B}¹) of a baseline from the chart;
similarly determining a diffraction intensity value (I_{B}²) of a baseline from a φ scan chart obtained from a second Miller index plane <h²k²1²>; and
using size relation between the I_{B}¹ value and the I_{B}² value as a criterion to determine the suitability as a raw material for producing single crystal silicon.

4. The method for selecting a polycrystalline silicon rod according to claim 3, wherein the first and second Miller index planes are a plane <111> and a plane <220>.

5. The method for selecting a polycrystalline silicon rod according to claim 4, wherein the polycrystalline silicon rod is selected as a raw material for producing single crystal silicon in the case where, when the plate sample is collected from a polycrystalline silicon rod having a radius of R at a position of R/3 or less from the center of the rod in the diameter direction and subjected to the φ scan to determine the diffraction intensity value (I_{B} value) of the baseline, the I_{B}^{<111>} value of the Miller index plane <111> is higher than the I_{B}^{<220>} value of the Miller index plane <220>; and when the plate sample is collected from the polycrystalline silicon rod having a radius of R at a position of 2R/3 or more and 3R/3 or less from the center of the rod in the diameter direction and subjected to the φ scan to determine the diffraction intensity value (I_{B}) of the baseline, the I_{B}^{<220>} value of the Miller index plane <220> is higher than the I_{B}^{<111>} value of the Miller index plane <111 >.

6. The method for selecting a polycrystalline silicon rod according to any one of claims 3 to 5, wherein the polycrystalline silicon rod is grown by the Siemens method.

7. A polycrystalline silicon rod selected by the method according to any one of claims 3 to 5.

8. A polycrystalline silicon block obtained by crushing the polycrystalline silicon rod according to claim 7.

9. A method for producing single crystal silicon using the polycrystalline silicon rod according to claim 7 as a silicon raw material.

10. A method for producing single crystal silicon using the polycrystalline silicon block according to claim 8 as a raw material.

## Amended claims

### Amended claims under Art. 19.1 PCT

**1.** Cancelled)

**2.** Cancelled)

**3.** Cancelled)

**4.** Cancelled)

**5.** (Amended)
A method for selecting a polycrystalline silicon rod to be used as a raw material for producing single crystal silicon, the polycrystalline silicon rod being grown by deposition by a chemical vapor deposition method, the method for selecting the polycrystalline silicon rod comprising:
collecting a plate sample having a section perpendicular to a diameter direction of the polycrystalline silicon rod as a principal plane;
disposing the plate sample at a position where Bragg reflection from a first Miller index plane <111> is detected;
rotating the plate sample in-plane about the center thereof by a rotation angle φ so that an X-ray irradiation region defined by a slit φ-scans the principal plane of the plate sample;
determining a chart showing the dependence of intensity of the Bragg reflection from the Miller index plane on the rotation angle (φ) of the plate sample;
determining a diffraction intensity value (I_{B}^{<111>} of a first baseline from the chart;
similarly determining a diffraction intensity value (I_{B}^{<220>}) of a second baseline from a φ scan chart obtained from a second Miller index plane <220>; and
selecting the polycrystalline silicon rod as a raw material for producing single crystal silicon when size relation between the I_{B}^{<111>} and the I_{B}^{<220>} satisfies the following two conditions at the same time:
Condition 1: the I_{B}^{<111>} and the I_{B}^{<220>}, obtained from the plate sample collected from the polycrystalline silicon rod having a radius of R at a position of R/3 or less from the center of the rod in the diameter direction, satisfy I_{B}^{<111>}I_{B} ^{<220>}; and
Condition 2: the I_{B}^{<111>} and the I_{B}^{<220>}, obtained from the plate sample collected from the polycrystalline silicon rod having a radius of R at a position of 2R/3 or more and 3R/3 or less from the center of the rod in the diameter direction, satisfy I_{B}^{<111>} < I_{B}^{<220>}.

**6.** (Amended)
The method for selecting a polycrystalline silicon rod according to claim 5, wherein the polycrystalline silicon rod is grown by the Siemens method.

**7.** (Amended)
A polycrystalline silicon rod selected by the method according to claim 5.

**8.** A polycrystalline silicon block obtained by crushing the polycrystalline silicon rod according to claim 7.

**9.** A method for producing single crystal silicon using the polycrystalline silicon rod according to claim 7 as a silicon raw material.

**10.** A method for producing single crystal silicon using the polycrystalline silicon block according to claim 8 as a raw material.
